(19) Europäisches Patentamt
European Patent Office
Office européen des brevets

(11) **EP 2 619 780 B1**

(12) **EUROPEAN PATENT SPECIFICATION**

(45) Date of publication and mention
of the grant of the patent:
**16.12.2015 Bulletin 2015/51**

(51) Int Cl.:
***H01H 1/00*** *(2006.01)*  ***H01H 59/00*** *(2006.01)*

(21) Application number: **11770225.8**

(22) Date of filing: **19.09.2011**

(86) International application number:
**PCT/US2011/052118**

(87) International publication number:
**WO 2012/040092 (29.03.2012 Gazette 2012/13)**

(54) **PULL UP ELECTRODE AND WAFFLE TYPE MICROSTRUCTURE**

HOCHZIEHELEKTRODE UND WAFFELARTIGE MIKROSTRUKTUR

ELECTRODE D'EXCURSION HAUTE ET MICRO-STRUCTURE GAUFREE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **21.09.2010 US 384840 P**

(43) Date of publication of application:
**31.07.2013 Bulletin 2013/31**

(73) Proprietor: **Cavendish Kinetics Inc.**
**San Jose, CA 95134 (US)**

(72) Inventors:
• **KNIPE, Richard L.**
**McKinney, TX 75071 (US)**
• **VAN KAMPEN, Robertus Petrus**
**5236 XR s-Hertogenbosch (NL)**
• **UNAMUNO, Anartz**
**6042 AN Roermond (NL)**
• **GADDI, Roberto**
**5212 CS s-Hertogenbosch (NL)**

(74) Representative: **Haley, Stephen**
**Gill Jennings & Every LLP**
**The Broadgate Tower**
**20 Primrose Street**
**London EC2A 2ES (GB)**

(56) References cited:
**EP-A1- 2 144 265**    **US-A1- 2003 042 117**
**US-A1- 2007 236 307**    **US-A1- 2010 116 632**

EP 2 619 780 B1

**Description**

BACKGROUND OF THE INVENTION

**Field of the Invention**

Embodiments of the present invention generally relate to a micro-electromechanical (MEMS) device and a method for its fabrication.

**Description of the Related Art**

As the size of semiconductors continues to shrink, so does the MEMS devices that are coupled to the semiconductors. MEMS devices may be used as miniature relay switches, capacitance switches, non-volatile memory elements and for many more applications. The MEMS devices have a switch or cantilever that moves between at least two positions to either permit or deny a current from flowing through the switch. The cantilever may be clamped at one or both ends.

MEMS devices are made using similar processing steps to those found in semiconductor foundries and therefore can be manufactured cost effectively on a wafer scale. One of the issues found in shrinking MEMS devices to the scale of less than a few micrometers is the ability of the switch or cantilever to be pulled into contact with an electrode and then released back to its original state. Due to the scale of the MEMS device, the cantilever or switch may not have enough restoring force to permit the switch or cantilever to return to its original state. The MEMS device performance will thus be negatively impacted.

Therefore, there is a need in the art for a MEMS device that is resilient enough to be pulled or pushed into contact with an electrode and then released back to its original position. There is also a need in the art for a method to manufacture such a device.

US 2003/0042117A1 discloses a MEMS device having a high-resonance-frequency beam. US 2010/0116632A1 discloses using a plurality of smaller MEMS devices to replace the function of a longer MEMS device.

SUMMARY OF THE INVENTION

The present invention generally relates to MEMS devices and methods for their manufacture. The cantilever of the MEMS device may have a waffle-type microstructure. The waffle-type microstructure utilizes the support beams to impart stiffness to the microstructure while permitting the support beam to flex. The waffle-type microstructure permits design of rigid structures in combination with flexible supports. Additionally, compound springs may be used to create very stiff springs to improve hot-switch performance of MEMS devices. To permit the MEMS devices to utilize higher RF voltages, a pull up electrode may be positioned above the cantilever to help pull the cantilever away from the contact electrode.

In one embodiment, there is disclosed a method of producing a micro-electromechanical device within a cavity that has one or more electrodes, one or more pull-in electrodes and an RF electrode disposed in the substrate, wherein the RF electrode is disposed between a first electrode of the one or more electrodes and a second electrode of the one or more electrodes. The method includes depositing a first sacrificial layer over a dielectric layer, depositing a first structural layer over the first sacrificial layer wherein the first structural layer is coupled to the first electrode of the one or more electrodes and the second electrode of the one or more electrodes, and depositing a second sacrificial layer over the first structural layer. The method also includes etching one or more first vias through the second sacrificial layer to expose at least a portion of the first structural layer. Additionally, a second structural layer is deposited within the one or more first vias and over the second sacrificial layer. The method also includes depositing a third sacrificial layer over the second structural layer. The method additionally includes etching the first sacrificial layer, the second sacrificial layer and the third sacrificial layer to free the first structural layer and the second structural layer within a cavity and form the micro-electromechanical device. The now freed micro-electromechanical device is able to move in response to voltages applied to electrodes.

In another embodiment, there is disclosed a micro-electromechanical device within a cavity that has one or more electrodes, one or more pull-in electrodes and an RF electrode disposed in the substrate, wherein the RF electrode is disposed between a first electrode of the one or more electrodes and a second electrode of the one or more electrodes. The device includes a first structural layer coupled to the first and second electrodes of the one or more electrodes and extending over an RF electrode and a second structural layer spaced from the first structural layer to define a space between the first structural layer and the second structural layer. The device also includes a plurality of posts disposed within the space and coupled between the first structural layer and the second structural layer, each of the plurality posts spaced from an adjacent post.

In a comparative example, a micro-electromechanical device is disclosed. The device includes a first structural layer coupled to one or more first electrodes and a second structural layer spaced from the first structural layer to define a space between the first structural layer and the second structural layer. The device also includes a plurality of posts disposed within the space and coupled between the first structural layer and the second structural layer. Each of the plurality posts are spaced from an adjacent post. The first structural layer, second structural layer, and plurality of posts collectively form a cantilever or suspended structure such as a bridge that is disposed within a cavity. The device also includes one or more compound springs that may or may not be electrically conductive. The one or more compound springs may be connected to the cantilever or suspended structure and disposed within the cavity.

## BRIEF DESCRIPTION OF THE DRAWINGS

So that the manner in which the above recited features of the present invention can be understood in detail, a more particular description of the invention, briefly summarized above, may be had by reference to embodiments, some of which are illustrated in the appended drawings. It is to be noted, however, that the appended drawings illustrate only typical embodiments of this invention and are therefore not to be considered limiting of its scope, for the invention may admit to other equally effective embodiments.

Figures 1A-1L show a MEMS device at various stages of manufacture

Figures 2A and 2B show a waffle-type cantilever according to one embodiment.

Figures 3A-3F show waffle-type MEMS devices that utilize compound spring technology.

Figures 4A-4C show the movement of a MEMS device according to one embodiment.

Figures 5A-5C are schematic illustrations of a MEMS device according to another embodiment.

To facilitate understanding, identical reference numerals have been used, where possible, to designate identical elements that are common to the figures. It is contemplated that elements disclosed in one embodiment may be beneficially utilized on other embodiments without specific recitation.

## DETAILED DESCRIPTION

The present invention generally relates to MEMS devices and methods for their manufacture. The cantilever of the MEMS device may have a waffle-type microstructure. The waffle-type microstructure utilizes the support beams to impart stiffness to the microstructure while permitting the support beam to flex. The waffle-type microstructure permits design of rigid structures in combination with flexible supports. Additionally, compound springs may be used to create very stiff springs to improve hot-switch performance of MEMS devices. To permit the MEMS devices to utilize higher RF voltages, one or more pull up electrode may be positioned above the cantilever to help pull the cantilever away from the contact electrode.

The waffle type structure discussed herein allows decoupling of the spring stiffness from the plate stiffness, providing a method to design rigid structures in combination with flexible supports. The waffle-type structure also allows the addition of compound springs that could be used to create very stiff springs to improve hot-switch performance of MEMS variable capacitors.

Due to the exponential increase of data transfer in mobile communications, soon it will be required to increase the capacity of the data handling. The use of tuneable components such as a MEMS Digital Variable Capacitor (DVC) could provide ways to increase data transfer capacity by allowing the resonant frequency of the aerial and digital DVC circuit to be matched to the incoming signal.

The performance of a MEMS DVC is mainly characterised by the RF specs, such as tuning ratio (*i.e.*, ratio of the high capacitance down state of the cantilever to the low capacitance up state of the cantilever), quality factor (*i.e.*, the ratio of the imaginary and the real part of the admittance), linearity (*i.e.*, the amount of distortion of the output signal relative to the input signal as the power level is increased), etc. It is to be understood that while the description will be made utilizing the term "cantilever", the term "cantilever" is meant to cover devices that are cantilevers as well as suspended structures such as bridges or movable structures that are anchored or clamped at the ends, yet movable in the middle. The DVCs also have operating specs, such as actuation voltage (*i.e.,* the voltage required to pull the cantilever down to the high capacitance state), hot-switch voltage (*i.e.*, the voltage on the RF electrode that will hold down the capacitor in the high capacitance state when the actuation voltage is just reduced to zero), capacitance density (*i.e.*, the capacitance per unit area), self-program and self-erase voltage, etc. The ideal specification of a DVC includes low actuation voltage (*i.e.*, voltage required to pull the MEMS cantilever down to the high capacitance state) and high hot-switch voltage. These two components of the ideal specification are generally opposing each other. The lower the actuation voltage, the lower the hot-switch voltage will be, because to get a low actuation voltage the spring constant of the MEMS cantilever needs to be low. To get a high hot switching voltage, a large spring constant is needed to pull the two RF plates apart when a large RF voltage is applied as the RF frequency is faster than the cantilever reaction time. This RF signal provides an average pull-in force. The pull in force can be increased for a given pull in voltage and gap by increasing the device area, but this adds to cost and is undesirable.

The methods presented here show methods of decoupling the stiffness of the support beams from the plate stiffness, therefore, obtaining low actuation voltages and being able to achieve higher hot-switch voltages for small area devices, as well as providing better stress control, a reduction in the complication of certain process steps and improved RF performance (*e.g.*, linearity). It also allows us to stiffen parts of the beam without increasing the mass as much as would occur if the beam was just to be made thicker in those parts.

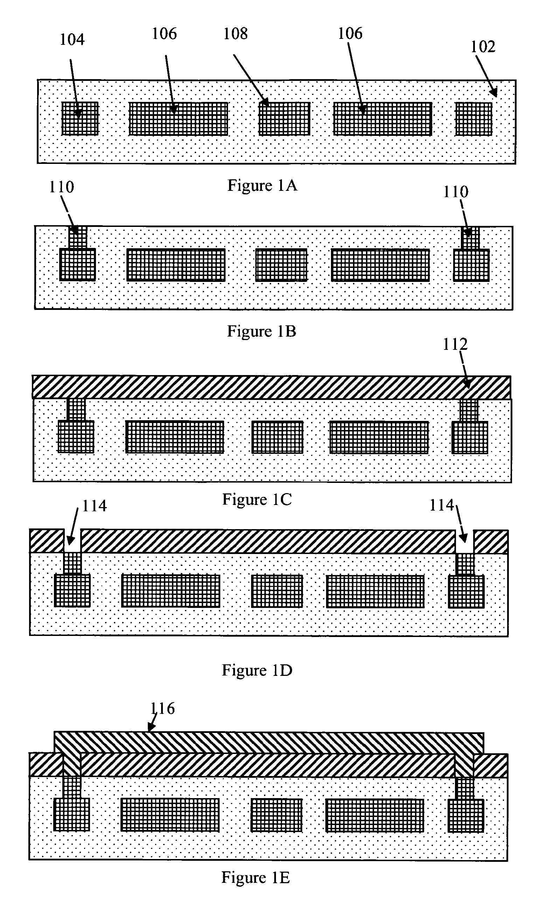

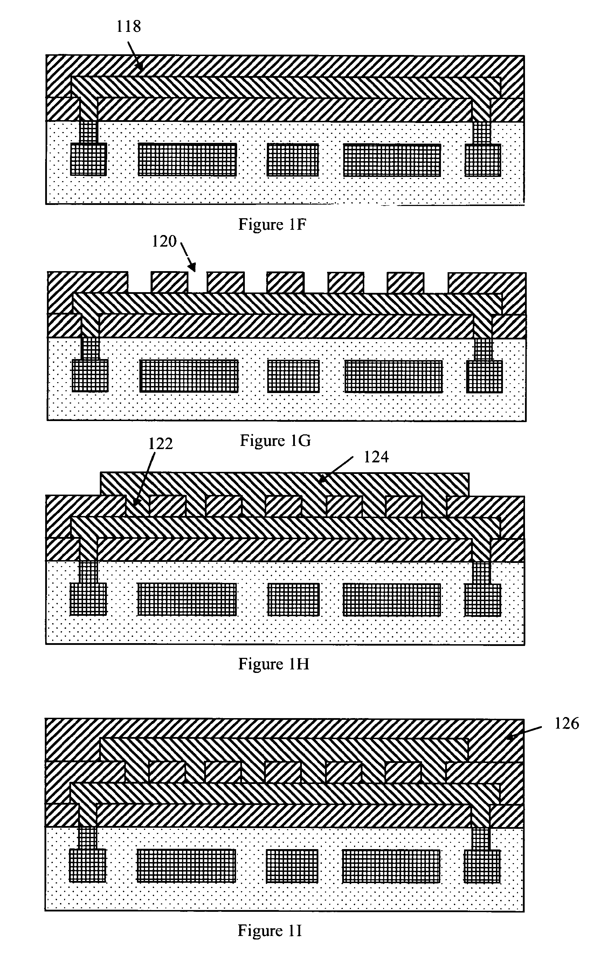

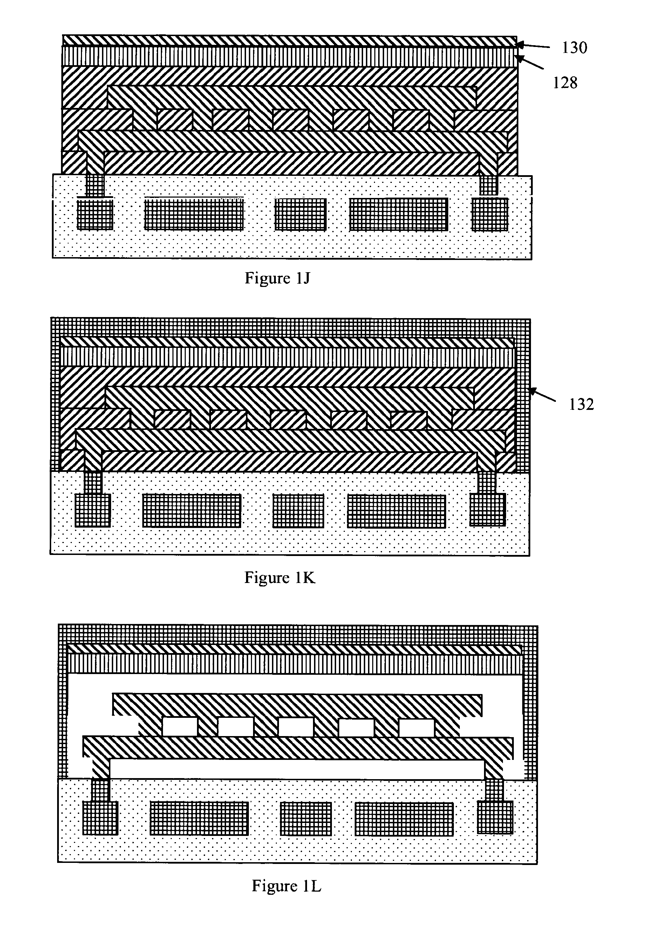

Figures 1A-1L show a MEMS device at various stages of manufacture. The device includes a dielectric layer 102 that may be formed within a semiconductor device such as the back end of the line (BEOL) of a complementary metal oxide semiconductor (CMOS) structure. Embedded within the dielectric layer 102 are one or more first electrodes 104 that are the metallization track that will make contact with the cantilever of the MEMS device. One or more pull-in electrodes 106 may also be embedded within the dielectric layer 102. The pull-in electrodes 106 may function to pull the cantilever into contact with the dielectric layer 102. Also embedded within the dielectric layer 102 is an RF electrode 108.

One or more vias may be etched into the dielectric layer 102 to expose the one or more first electrodes 104. The vias may then be filled with electrically conductive material 110 that is used to make an electrical connection between the one or more first electrodes 104 and the cantilever structure. In one embodiment, the electrically conductive material 110 may comprise a metal. In another embodiment, the electrically conductive material 110 may comprise a material selected from the group consisting of titanium, tantalum, titanium nitride, tantalum nitride, copper, aluminum, and combinations thereof.

A first sacrificial layer 112 is then deposited over the dielectric layer 102. The first sacrificial layer 112 is used to define the spacing between the upper surface of the dielectric layer 102 and the bottom surface of the cantilever. The first sacrificial layer 112 may be deposited by a process such as plasma enhanced chemical vapour deposition (PECVD), chemical vapour deposition (CVD), spin-on technologies, and physical vapour deposition (PVD) to name a few. In one embodiment, the first sacrificial layer 112 may comprise a silicon containing compound. In another embodiment, the first sacrificial layer 112 may comprise silicon dioxide. In another embodiment, the first sacrificial layer 112 may comprise spin-on glass or spin on dielectric containing a long chain molecule with a carbon backbone. Such a material would need to have a low silicon content, because the sacrificial etch to remove carbon based compounds often leaves residues if they contain silicon.

One or more vias 114 are then etched through the first sacrificial layer 112 to expose the underlying electrically conductive material 110. In one embodiment, the dielectric layer 102 may be etched after the one or more vias 114 are formed. In any event, the one or more vias 114 are then filled with the material used to form the first structural layer 116. The filled vias 114 provide the electrical connection between the electrodes 104 and the cantilever. The first structural layer 116 will be the bottom portion of the cantilever once the device is formed. In one embodiment, the first structural layer 116 may comprise a metal. In another embodiment, the first structural layer 116 may comprise a material selected from the group consisting of titanium, tantalum, titanium nitride, tantalum nitride, copper, aluminum, and combinations thereof. In another embodiment, the structural layer 116 may comprise a multi-layer structure. For example, a 5-layer stack (TiN-Al-Tin-Al-TiN) may be utilized. Each titanium nitride layer may have a thickness of less than 100nm to avoid issues with TiN grains. Other materials that may be used in a multi-layer structure include TiAl and TiAlN. In another embodiment the structural layer 116 may consist of a tri layer structure such as TiN then Al then TiN. The tri-layer structure combines the strength advantages of TiN which has a high resistivity with the low resistance properties of Al which has poor mechanical strength. By sandwiching a thin Al layer between two TiN layers any residual stress difference in the deposition of the two materials will not cause differential stress in the MEMS structure. In addition, differences in the thermal expansions between the two materials will not cause differential stress in a symmetric TiN-Al-TiN sandwich layer. An additional advantage of such a structure is that the mechanical strength of TiN films is reduced at greater thickness of film. This is because of increased voids at increasing deposition thicknesses. By stopping the deposition of the TiN at around 200nm putting down a thin Al layer and commencing growth, this problem can be greatly reduced. The first structural layer 116 may then be etched to form the final shape of the first structural layer 116. The first structural layer 116 may be deposited by well known techniques such as sputtering, electroless plating and electrochemical plating.

A second sacrificial layer 118 is then deposited over the first structural layer 116. Similar to the first sacrificial layer 112, the second sacrificial layer 118 may be deposited by a process such as PECVD, CVD, spin-on technologies, and PVD. In one embodiment, the second sacrificial layer 118 may comprise a silicon containing compound. In another embodiment, the second sacrificial layer 118 may comprise silicon dioxide. In another embodiment, the second sacrificial layer 118 may comprise spin-on glass or spin on dielectric containing a long chain carbon molecule and with a low silicon content as discussed above. A plurality of vias 120 are then etched through the second sacrificial layer 118 to expose at least a portion of the underlying first structural layer 116. The second sacrificial layer 118 is used to provide a spacing between the first structural layer 116 and the second structural layer 124. Electrically conductive material is deposited into the vias 120 to form posts 122. The posts 122 are used to provide a connection between the first structural layer 116 and the second structural layer 124. The second structural layer 124 is then deposited over the posts 122 and the second sacrificial layer 118. The first structural layer 112, the posts 122 and the second structural layer 124 collectively form the waffle-type structure once all of the sacrificial material as been removed to free the device. Similar to the first structural layer 116, the posts 122 and second structural layer 124 may comprise a metal. In another embodiment, the second structural layer 124 and posts 122 may comprise a material selected from the group consisting of titanium, tantalum, titanium nitride, tantalum nitride, copper, aluminum, and combinations thereof. The second structural layer 124 and posts 122 may be deposited by well known techniques such as sputtering, electroless plating and electrochemical plating. To simplify the number of process steps after the second sacrificial layer 118 has been exposed and via holes etched into it, the second structural layer 124 may be added during the formation of the posts 122. The second structural layer then forms a continuous film over the second sacrificial layer 118 that makes mechanical contact with the first structural layer 116.

A third sacrificial layer 126 is then deposited over the second structural layer 124. The third sacrificial layer 126 is used to provide a spacing between the top of the device, which in this embodiment is the second structural layer 12, and the pull-up electrode 130. Similar to the first and second sacrificial layers 112, 118, the third sacrificial layer 126 may be deposited by a process such as PECVD, CVD, spin-on technologies, and PVD. In one embodiment, the third sacrificial layer 126 may comprise a silicon containing compound. In another embodiment, the third sacrificial layer 126 may comprise silicon dioxide. In another embodiment, the third sacrificial layer 126 may comprise spin-on glass or spin on dielectric. Because many spin-on dielectrics have a large thermal expansion coefficient, during curing of the spin on material it is important to cure the lower sacrificial layers at a higher temperature than the higher layers. This reduces the possibility that annealing the top sacrificial layers will cause thermal expansion of the lower sacrificial layer to such an extent that they cause damage to the intervening mechanical cantilever layers.

In one embodiment, a pull-up electrode 130 is then formed over the third sacrificial layer 126 on top of an insulating layer 128. The pull-up electrode 130 may be used to pull the cantilever away from the bottom of the cavity and up to the insulating layer 128. The insulating layer 128 is there to prevent the top layer 124 of the grounded cantilever from shorting to the pull up electrode 130. The insulating layer 128 may be made from silicon, silicon nitride, silicon oxide or some combination of the two. The pull-up electrode 130, if present, may comprise a metal. In another embodiment, the pull-up electrode 130 may comprise a material selected from the group consisting of titanium, tantalum, titanium nitride, tantalum nitride, copper, aluminum, and combinations thereof. The pull-up electrode 130 may be deposited by well known techniques such as sputtering, electroless plating and electrochemical plating. It is to be understood that the device may be formed without the use of a pull-up electrode 130.

An encapsulating layer 132 is then formed over the third sacrificial layer 126 and, if present, the pull-up electrode 130. The encapsulating layer 130 is used to define the outside boundary of the cavity. In one embodiment, the encapsulating layer 130 may comprise silicon based materials. In another embodiment, the encapsulating layer 132 may comprise silicon oxide, silicon nitride, silicon oxynitride, or combinations thereof. The encapsulating layer 132 may be deposited by well known techniques such as PECVD and CVD. In one embodiment, the encapsulating layer 132 is deposited so that at least a portion of one or more of the first sacrificial layer 112, the second sacrificial layer 118, or the third sacrificial layer 126 extends outside of the encapsulating layer 132. In another embodiment, a hole is etched through the encapsulating layer 132 to expose one or more of the first sacrificial layer 112, the second sacrificial layer 118, or the third sacrificial layer 126. The hole through the top may be positioned so that it is over the base ends of the double clamped cantilever, so that when the hole is sealed the material sealing the hole comes down through the hole to provide increased mechanical support for the ends of the cantilever.

An etchant is then introduced through the hole (or exposed to the sacrificial material extending outside of the encapsulating layer 132). The etchant selectively etches the first sacrificial layer 112, the second sacrificial layer 118 and the third sacrificial layer 126 to remove the sacrificial material. The first structural layer 116, posts 122 and second structural layer 124 remain within a cavity 132. The cavity 132 may then be sealed by depositing a second encapsulating or sealing layer (not shown). It is advantageous to design the cavity so that the top sacrificial layer is removed before the other sacrificial layers. Having holes come through the top layer 132 above the ends of the MEMS device helps in this process. This is important because if there is a temperature rise during the etch process the cavity top may move. If the sacrificial layer is removed first from above the cantilever device then the lower sacrificial layers hold it in place and the top cavity movement does not cause increased strain on the cantilever. If the bottom sacrificial layer were to etch first then the cantilever device would be stuck to the top of the cavity by the top sacrificial layer and thus movement of the cavity could damage the cantilever device. By curing the lower sacrificial layers for longer they take longer to etch. To prevent unwanted charging of the oxide during the release process it is important to ensure that there are few OH molecules present during the etching. When using plasma etching the ionic etchant ions are produced in a plasma outside the cavity and diffuse in through the cavity holes. Because the cantilever may be a grounded metal, the ionic concentration is then greatly reduced and the etch rate decreases. To solve this problem the conducting metal surface can be coated with a layer of insulator. This can be an insulating layer deposited just after the metal layer is put down. It can be a silicon based material or silicon oxide or silicon nitride or other dielectric material. The cavity may then be sealed by depositing a sealing layer over the hole.

Once the first, second and third sacrificial layers have been removed, the first structural layer 116, posts 122 and second structural layer 124 are movable within the cavity between a position wherein the first structural layer 116 is in contact with the dielectric layer 102 and a position wherein the first structural layer 116 is spaced from the dielectric layer 102. Additionally, if the pull-up electrode 130 is present, the first structural layer 116, posts 122 and second structural layer 124 are movable between a position wherein the second structural layer 124 is in contact with the insulator layer 128 under the pull-up electrode 130 and a position wherein the second structural layer 124 is spaced from the pull-up electrode 128. The final structure shows a waffle-type cantilever structure.

The waffle-type cantilever structure has many advantages. One of the advantages is that the structure provides a way for independent tuning of plate rigidity and suspension springs. The length of the posts 122, the number of posts 122, the thickness of the structural layers 116, 124, and the shape of the structural layers 116, 124 may all be tailored to obtain a rigidity that suits the end user's needs.

Another advantage is that the waffle-type structure enables the creation of compound springs. Placing the compound springs further from the RF electrode results in a reduction of the hot-switch spec. However, the stiffer the waffle-type structure becomes, the less the loss of hot-switch capability is.

Another advantage of the waffle-type structure is that it is a low mass way of increasing stiffness, therefore reducing momentum, travelling time and impact effects and increasing reliability.

Another advantage of the waffle-type structure is that the top and bottom of the membrane can be shaped to improve actuation areas or processing spacing requirements. Additionally, the two depositions for the structural layers 116, 124 can be the same so they have the same stress and thus no differential stress and this also reduces process development efforts. The waffle-type structure can have two sets of bi-layers so that there is no net differential stress. The waffle-type structure reduces deposition time and material use. Additionally, there is an improved RF linearity as the stiffer plate would deflect less with voltages applied on the RF electrode.

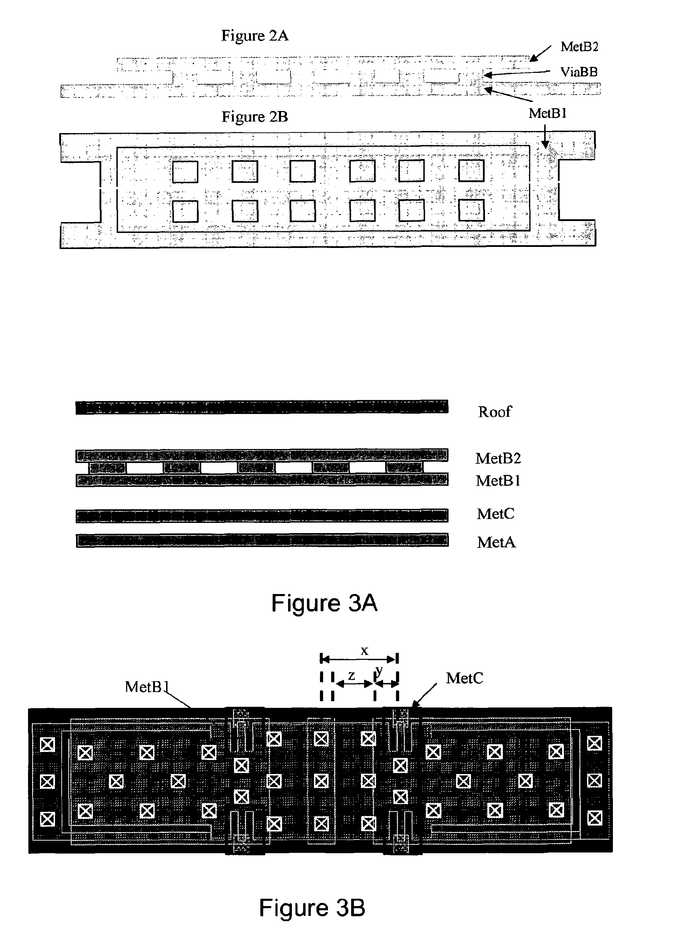

The maximum stiffness is defined by the distance between the two layers, as it is required to have good step coverage of the ViaBBs which connect the MetB1 layer and the MetB2 layer as shown in Figure 2A. Figure 2B is a top view of Figure 2A.

The electrostatic force for a parallel plate system can be described by the equation,

$$F = \frac{\varepsilon_0 A V^2}{2g^2},$$

where 'F' is the electrostatic force, '$\varepsilon_0$' is the permittivity of a vacuum, 'A' is the area of interaction, 'V' is the voltage difference and 'g' is the distance between the electrostatic plates.

If we consider the application of a MEMS cantilever as one of the plates of a variable capacitor, then one of the desired attributes is a large capacitance ratio. The capacitance is a function of the inverse of the distance between the two plates '1/g', and therefore to obtain a larger ratio, it is required to have a large change in gap. To get the large gap will require an increase in the pull-in force (derived from the electrostatic force equation).

In order to avoid charging of a dielectric layer placed over the pull-in electrodes (to prevent shorting when the plate touches the pull-in electrode), low actuation voltages should be used, and the area of the pull-in electrodes should be limited to make a device with a reasonable capacitance density. As the degrees of freedom to change the electrostatic force are limited by RF performance (a large gap is required to obtain the tuning ratio), the only way to reduce the actuation voltage is to reduce the mechanical stiffness involved in the pull-down process.

Flexible supporting springs can be used to obtain low actuation voltages in an electrostatically actuated device. However, if the plate is built using the same layer as the support beams, the stiffness of the plate would also be low, and as a consequence the hot-switch voltage would be lower than the actuation voltage.

To have a higher hot-switch voltage, a compound spring can be added, and to increase the efficiency of the compound spring, a stiff plate may be used. The stiffness of the digital variable capacitor plate between the compound springs can be approximated by a simply supported plate with uniformly distributed load, which is given by the equation:

$$K = \frac{\alpha * E * t^3}{L^4},$$

where '$\alpha$' is a constant, 'E' is the young's modulus given by the material used, 't' is the thickness of the plate, and 'L' is the distance between the supports. This equation shows that if the distance between the supports (compound springs) is large, the stiffness of the plate becomes very small (1/L^4), which would make the hot-switch voltage small.

As the distance between the compound springs is given by the width of the RF electrode (one cannot put compound springs on top of the RF line because the capacitance ratio then goes down) increasing the thickness of the structure is how a stiffer structure can be obtained. This is where the waffle structure shown in Figures 2A and 2B becomes of interest.

The waffle-structure of Figures 2A and 2B could be built using the following process starting with the MetB1 layer (excluding the anchor and whatever is below the MetB1). First, layer MetB1 may be deposited, patterned and etched on a sacrificial layer anchored to the substrate contact. Then, a sacrificial material is deposited or spin coated onto MetB1. Openings (ViaBB) may be formed in the sacrificial material. Then, the MetB2 layer may be deposited, patterned and etched. The MetB2 will deposit within the ViaBBs. A top sacrificial layer may then be deposited or spin deposited onto the MetB2 and patterned. One or more cavity cap layers may then be deposited. One or more openings may be etched into the cavity to permit introduction of etching gas/solution to the sacrificial layers. The etching gases/solution may be introduced through the openings to etch/remove the sacrificial layers and release the waffle structure. The cavity may then be sealed.

The support springs will then be defined in MetB1 which can be thin, and therefore, the pull-down voltage would be low. The compound springs (not shown in the picture) would be at either side of the RF electrode, and the stiffness of the plate between the compound springs would be increased due to the thickness added using the MetB2 after the spacer.

The stiffness of the waffle structure is not the same as having a film with the thickness of MetB1+ViaBB+MetB2. However the method can be used to increase the stiffness without using very thick metal layers, which are difficult to etch and to control the stress during deposition.

Figures 3A-3F show waffle-type MEMS devices that utilize compound spring technology. As shown in Figure 3A, MetA is used to route and create control and RF electrodes. MetC can be electrically connected or not electrically connected to MetA and is used to strengthen and to create a stopper where the MetB1 can contact as explained below. MetB1 and MetB2 are the switch itself. It is possible to have compound spring legs in both layers. For example, the ones in MetB1 can land on a MetC stopper, and the ones in MetB2 can land on a solid MetB1 piece. The compound spring is a piece of material that comes out from the main plate and lands on a metal (could also be other material) that is located at a different level.

As shown in Figure 3B, the MetB1 legs land on a MetC stopper. In this case, the distance between the leg and the stopper is set by the sacrificial layer thickness (maximum negative vertical displacement of the switch) and the thickness of MetC. Assuming the plate does not bend, the geometry (length, width and thickness), material, and the height of MetC define the hot-switch voltage of the switch for a given force created by the RF electrode. In reality, the plate bends, and some of the force available in the compound spring technology is not used for the hot-switching. The closer the compound spring is to the RF line, the more efficiently the force can be used to hot-switch the voltage in the RF electrode.

On the other hand, to obtain for RF capacitors it is desired to be flat at the RF electrode at the maximum capacitance to avoid IP3 inter-modulation issues. This requires that a piece of electrode (see marked as 'y' in Figure 3B) is available in the inner side towards the RF line. The section shown as 'z' in Figure 3B is also required to reduce parasitic coupling. The larger the gap, the better the parasitic decoupling: however hot-switch capabilities are lost.

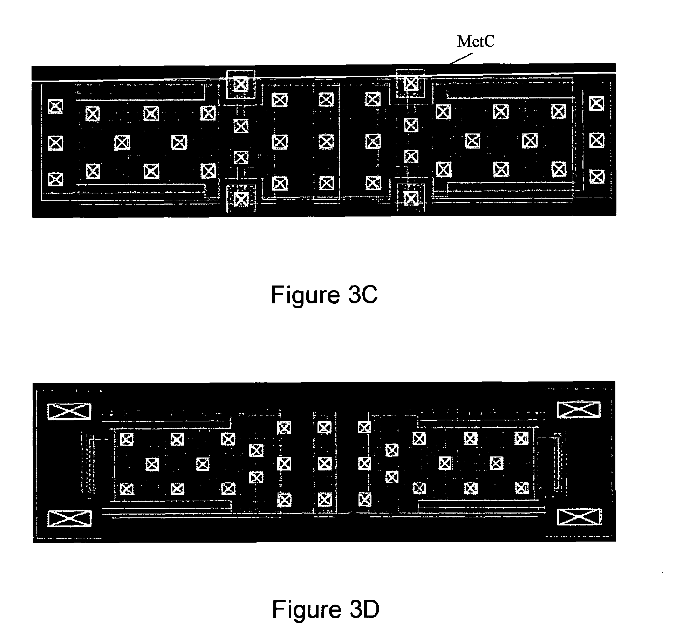

The same principle can be used by making a MetB2 leg land on a MetC+MetB1 stack as shown in Figure 3C. Figure 3C shows a switch with compound springs in MetB2 landing on a solid MetC-MetB1 stack.

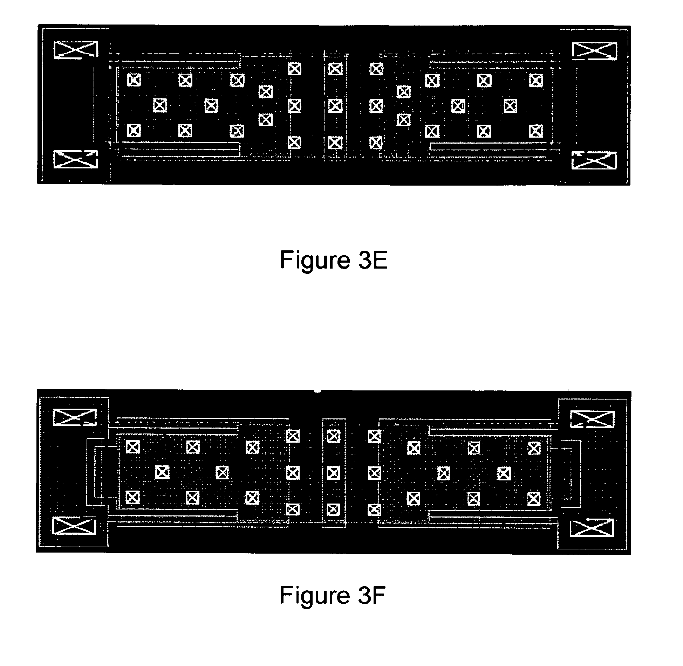

The plate bending devices do not make use of the compound spring technology legs, and instead the tips of the plate land on MetB1 or MetC stoppers, having similar effects as described in previous sections. Having the contact at the end of the plate reduces the efficiency for the hot-switch; however, it is a good method to reduce the contact area between the control electrode and the plate, and therefore reduce the stuck failures. Figure 3D shows a device using the plate bending technique with the MetB1 of the plate landing on a MetC stopper near the plate-anchors. In the same way, the plate bending technique can be used by landing the MetB2 of the plate on a MetB1 bridge near the plate-anchors as shown in Figure 3E.

Stoppers to the top may also be added to avoid stiction to the roof. This has been achieved using a plate bending configuration where the MetB1 section at the end of the plate makes contact with a MetB2 piece that comes from the anchor. In this case the engagement range is defined by the thickness difference between the sacrificial layers, MetB1-MetB2 and MetB2-Roof. Figure 3F shows a possible configuration. In Figure 3F MetB1 stops on a MetB2 stopper before it hits the roof, and forces the plate to bend, reducing contact area between the plate and the roof electrode.

It is possible to combine compound spring technology legs with plate bending options in order to obtain a large hot-switch voltage and also a reduced contact area to avoid failure of the device due to stiction or oxide charging. Making use of sacrificial thicknesses, it is possible to create multi-stage compound springs, where a MetB2 leg could land on MetB1 (solid block or switch leg) and a little further in the pull process the MetB1 could land on an MetC stopper, creating a non-linear spring with three linear sections. This number of linear sections could be extended if required.

This invention relates to MEMS switches and in particular to RF MEMS switches where the MEMS cantilever acts as one arm of a capacitance switch which comes close to an RF electrode under the MEMS switch in the high capacitance state, and is pulled away from the RF electrode in the low capacitance state. A second electrode under the MEMS switch is used to pull the cantilever down. If the RF signal is large this AC voltage on the electrode will be faster than the resonant frequency of the MEMS cantilever, but it will still provide an average pull-in force because it is the difference in voltage between the MEMS cantilever and the RF electrode that causes and attractive force. Therefore the cantilever will experience a pulse of attractive force when the RF voltage goes negative and another one when it goes positive. To allow larger RF voltages being used we propose adding an extra pull up electrode above the MEMS cantilever. This can be actuated to move the MEMS cantilever further from the pull down electrode and it also provides a large holding force which prevents the cantilever being pulled in by high RF fields sustaining much higher RF voltages. This would also work if the device was being operated as a DC switch with the RF electrode being replaced by a DC voltage line. In the above example the MEMS cantilever is assumed to be at DC ground potential.

The problem is that many MEMS devices have three terminals with an actuation voltage being applied to a pull-in electrode to bring a MEMS moving part into contact with a third landing electrode. If the landing electrode also has a voltage signal applied to it, there will be an attractive force between that electrode and the cantilever. In the example below, the MEMS cantilever touches down on a thin oxide layer above the landing electrode which is a radio frequency line. Therefore there is an increase in capacitance coupling between the MEMS cantilever and the RF landing electrode as the MEMS cantilever gets closer to the thin insulating layer above the RF electrode. The pull-in electrode on the same side of the MEMS switch is used to alter the Cantilever position and thus the capacitance coupling of the RF line to the DC grounded cantilever. A large voltage signal applied to the RF electrode can cause self actuation of the MEMS device. This could pull the MEMS cantilever down and thus alter the capacitance without a voltage being applied to the pull-in electrode. Previously this problem was solved by making the MEMS cantilever stiffer so that it would not self actuate from large signals on the landing RF electrode. The problem with this is that this means that a larger force is then required to switch the device using the actuation electrode. This can be achieved by increasing the area of the pull-in electrode with the MEMS cantilever, which has the drawback of increasing the devices size and introducing larger unwanted stray capacitance between the RF electrode and the pull-in electrode. Alternatively, the voltage can be increased on the pull-in electrode, which has the problem of charge leakage into nearby insulators and a reduction in lifetime, as well as increased cost of providing charge pumps.

A pull up electrode may be used which moves the MEMS cantilever further away from the RF electrode. The pull-in force is approximately proportional to the square of the electric field. Therefore doubling the spacing will increase the self actuation voltage by a factor of four. In addition, with the cantilever pulled to the top, the cantilever is much closer to the top and so the electrostatic force from the top is greatly increased. If there is an insulator of thickness t with relative permittivity $\varepsilon_r$ between the pull-up electrode and the MEMS cantilever when it is in the up state and the MEMS cantilever is now 2d away from the RF electrode, then a voltage $V_{top}$ on the top would provide an electrostatic pull-up force greater than a voltage $V_{RF}$ if

$$\frac{A_{top} \cdot V_{top}^2}{\left(t/\varepsilon_r\right)^2} > \frac{A_{RF} \cdot V_{RF}^2}{(2d)^2} .$$

If t=d/2 and $\varepsilon_r$=4 then $V_{RF}$ would need to be 16 times $V_{top}$ to pull the cantilever back down if $A_{top}=A_{RF}$. However, in most cases the pull up area $A_{top}$ is also greater than that of the RF landing electrode $A_{RF}$ adding extra effectiveness to the top voltage pull.

This technique is particularly relevant to a DVC consisting of an array of MEMS capacitors that are programmed to be either touching the cavity roof (pull up electrode with insulator under it), which is the low capacitance state, or touching down on the thin insulator over the RF electrode, which is the high capacitance state. The desired capacitance is achieved by configuring the appropriate number of MEMS switches to either be in up or down state. Thus, only one voltage need be applied to hold each cantilever up and another is required to hold it down. When trying to keep each MEMS cantilever at an intermediate given height in between being pulled to the top or the bottom RF electrode, then the pull-up voltage would have to be continually adjusted to counteract changes of power in the pull down electrode. This would require complicated fast feedback related to the instantaneous RF power.

A pull-up electrode may be present to move a cantilever within a cavity. The advantage of adding the pull-up electrode is that for the same design of a device, the self actuation voltage can be greatly increased. Self actuation is the voltage at which a signal on the RF line causes the MEMS switch to actuate in an unwanted manner. It allows a smaller and lower voltage device to be made which has the same self actuation voltage as a device without a pull up electrode.

Of great relevance is also the improved linearity performance of the MEMS switch. The RF self actuation is the main cause of non-linearity in the case of an electrostatically actuated MEMS switch or variable capacitor. The variations of instantaneous RF power generate a time-varying non-linear capacitance between the RF electrode and the MEMS cantilever electrode. The amount of capacitance variation for a given RF power range is greatly reduced by actively pulling the MEMS cantilever to the top. The resulting intermodulation distortion due to the non-linear capacitance is greatly reduced. There needs to be a separate contact to a top pull up electrode. The control circuitry needs to generate two control voltages in order to operate the MEMS switch device.

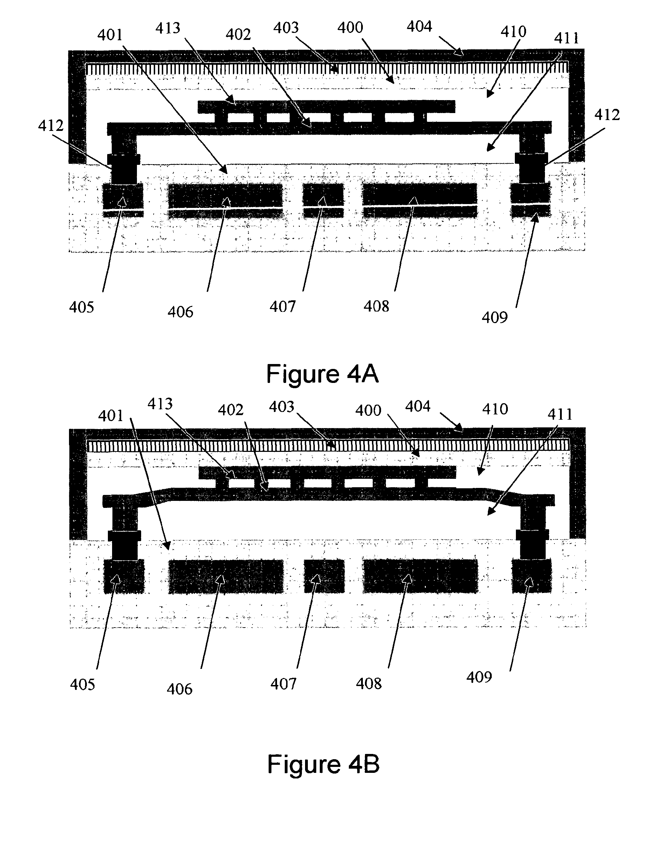

In Figures 4A-4C, the use of the pull up electrode in relation to a DVC where there is an array of MEMS cantilever bridges that have two possible capacitance states, either pulled down (high capacitance state) or pulled up (low capacitance state) is shown. However the same advantage would be gained if the MEMS cantilever was to be used as a switch which is either down (on) or up (off). The pull up electrode would then prevent large signals on the landing electrode pulling down the MEMS cantilever to make electrical contact to the down electrode.

In Figures 4A-4C, layer 401 is an insulating layer formed over the metallization track 405, 409, RF line 407, and pull-in electrodes 406, 408. The cantilever 402 is formed over the insulating layer 401. In one embodiment, the cantilever 402 may comprise a conductive material. In another embodiment, the cantilever 402 may comprise titanium nitride. Another insulating layer 400 may be present to cover the pull-up electrode 403. In one embodiment, insulating layer 400 may comprise silicon dioxide, silicon nitride, or combinations thereof. The metallization track 405, 409 make contact to the cantilever 402. The regions 410 and 411 are the cavity space. These regions 410, 411 previously contained a sacrificial layer which is removed out of the cavity during a release etch process. Layer 412 is a via through insulating layer 401 to allow the cantilever 402 to connect to the metallization track 409.

The devices can be made by initially depositing the metal tracks 405, 406, 407, 408 and 409 on an insulating substrate. A second insulating layer is deposited on top of these tracks. A chemical mechanical polishing process may be performed to planarize back to the metal tracks 405 to 409. A third thin insulating layer 401 is deposited. Insulating layer 401 covers the electrodes. Vias 412 are made through the insulating layer 401 using optical lithography followed by etching to open the holes, then metal deposition, a further lithography stage and etching to leave the vias as shown. A sacrificial layer is then spun-on which could be a silicon free spin-on material that is then patterned to create the region 411 which will eventually be the cavity under the MEMS cantilever to allow the cantilever section 402 to connect to the vias 412. The cantilever 402 may be designed to have a waffle like stiffening region in the middle (layer 413). This is made by spinning on a sacrificial layer on to the cantilever layer 403, etching via holes through it and then adding a second cantilever layer (could be TiN on top) creating via connections to the cantilever layer 402. A final sacrificial layer is spun-on top of the cantilever and stiffening structure to create the cavity 410. A hole is etched through the top or side of layer 403, 400 and 404 to allow etch gasses to remove all the sacrificial layers. These holes are then sealed in the same machine that etches the sacrificial layer so that the cavity can be sealed in a low pressure state. With an organic spin-on material the etchants may be reactive oxygen or hydrogen radicals. It is important to minimize the quantity of OH groups within the etch process, because they can lead to charging of the oxide which leads to unwanted actuation of the device during release.

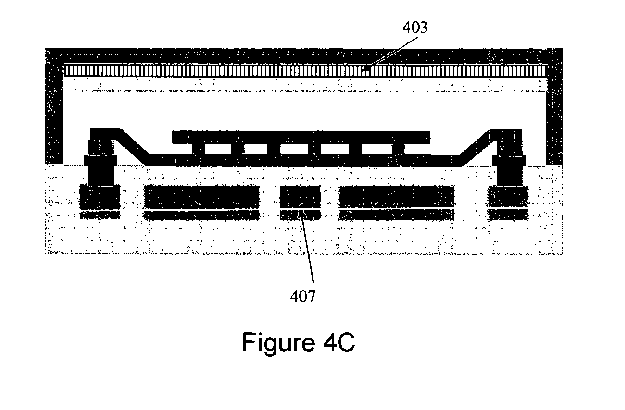

In Figure 4B, electrode 403 is used to pull cantilever 402 to touch insulating layer 400. Electrode 403 holds cantilever 402 so that it can not be pulled down onto RF electrode 407 when there is a high power signal applied to it. Figure 4C shows the cantilever 402 pulled down by applying voltages to electrodes 406 and 408 while turning off the pull-up voltage on electrode 403. This pulls the cantilever down onto the insulator 401 above electrode 407. In both Figures 4B and 4C, the cantilever 402 is spaced from the electrodes by an insulating layer. Figures 4B and 4C show one of the digital capacitors that can implement the DVC in the two capacitance states, either low capacitance pulled up to the insulating layer 403 under the pull-up electrode 404, or in the high capacitance state, pulled down onto the insulating layer 401 over the RF electrode 407.

If the insulating layer 400 is of thickness t between the pull-up electrode 403 and the MEMS cantilever 413 when it is in the up state and the MEMS cantilever is 2d away from the RF electrode, then a voltage $V_{top}$ to the pull-up electrode 403 would provide an electrostatic pull-up force greater than a voltage $V_{RF}$ if

$$\frac{A_{top}.V_{top}^2}{\left(t/\varepsilon_r\right)^2} > \frac{A_{RF}.V_{RF}^2}{(2d)^2}.$$

(where $\varepsilon r$ is the relative dielectric for the top oxide which will be greater than 1). If t=d/2 then $V_{RF}$ would need to be at least 16 times $V_{top}$ to pull the cantilever back down if $A_{top}=A_{RF}$. In most cases the pull up area is also greater as it covers the whole roof of the cavity and so covers most of the MEMS cantilever, in which case the RF-voltage required to pull the cantilever back down would be increased even further. Thus, the pull-up electrode 403 may help improve the performance of the DVC.

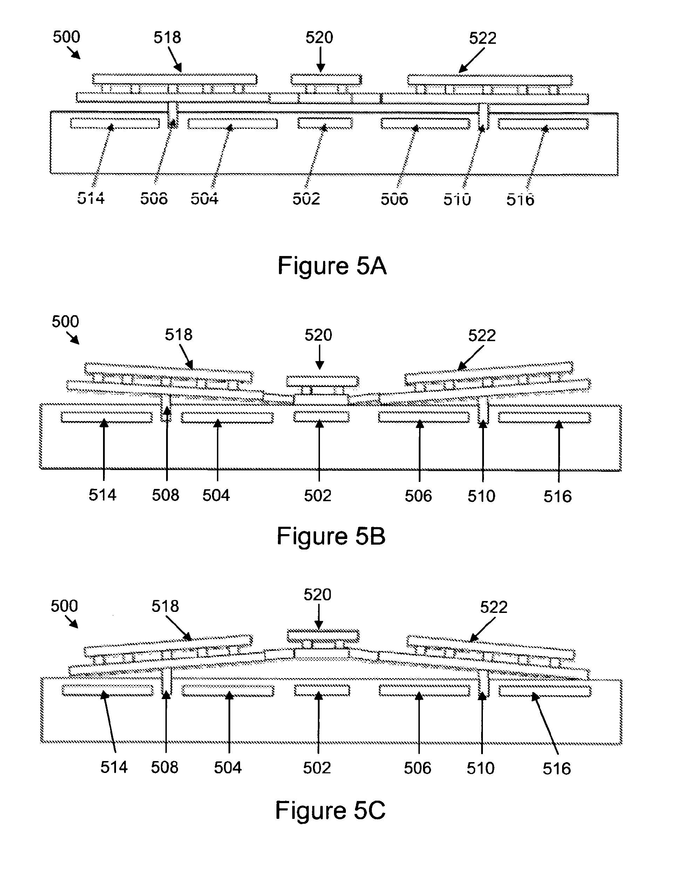

Figures 5A-5C are schematic illustrations of a MEMS device 500 according to another embodiment. The MEMS device includes an RF electrode 502, electrodes 504, 506 that are used to pull in the cantilever such that the center portion 520 is brought in close proximity to the RF electrode 502, pivot points 508, 510, electrodes 514, 516 that are used to pull the MEMS cantilever central portion 520 away from the RF electrode 502, and two cantilever end portions 518, 522 that pivot on pivot points 508, 510 respectively.

As shown in Figure 5A, the cantilever structure includes end portions 518, 522 as well as a central portion 520. The central portion 520 moves from a position that is in close proximity to the RF electrode 502 (shown in Figure 5B) and a position that is spaced far away from the RF electrode 502 (shown in Figure 5C). When the central portion 520 is spaced in close proximity to the RF electrode 502, a portion of the end electrodes 518, 522 are pulled into close proximity to electrodes 504, 506. However, when the central portion 520 is spaced far away from the RF electrode 502, opposite ends of the end electrodes 518, 522 are in close proximity to electrodes 514, 516. The cantilever portions are only in close proximity rather than direct contact with the electrodes due to the presence of an insulating layer over the electrodes.

In operation, the MEMS device 500 operates as follows. The central portion 520 may be spaced from RF electrode 502 while the end portions 518, 522 may be spaced from electrodes 504, 506, 514, 516 as shown in Figure 5A.

Thereafter, an electrical bias is applied to one or both of electrodes 504, 506 and the central portion 520 is pulled into close proximity of RF electrode 502 as shown in Figure 5B. In so moving, the end portions 518, 522 pivot on pivot points 508, 510 such that a portion of the end portions 518, 522 are placed into close proximity of electrodes 504, 506. During this time, electrodes 514, 516 may be either at ground or floating potential.

Thereafter, to move the central portion 520 from being in close proximity to the RF electrode 502, the central portion 520 may be pulled-off as shown in Figure 5C. To pull-off the central portion 520, bias to electrodes 504, 506 is removed such that electrodes 504, 506 are either floating, grounded, or even at the opposite potential from which bias was applied to pull the central portion 520 into close proximity of RF electrode 502. A bias may be applied to electrodes 514, 516 such that the end portions 518, 522 pivot about pivot points 508, 510 and pull-off the central portion 520 and move the central portion 520 to a position far away from RF electrode 502. In so moving, the opposite ends of the end portions 518, 522 are positioned in close proximity to electrodes 514, 516.

It is to be understood that while the electrodes disclosed herein have been referred to as "pull-up" electrodes, the electrodes need not necessarily need to be physically located above the cantilever structure. Rather, the "pull-up" electrodes may simply be pull-off electrodes that operate to pull the cantilever electrode from one position to another position. Thus, in all of the descriptions herein, the term "pull-up" encompasses not only electrodes that are physically located above the cantilever structure, but more broadly, electrodes that operate to pull off the cantilever structure. It is also to be understood that while the embodiments discussed herein have referred to utilizing titanium nitride as the materials for the cantilever structures, titanium-aluminum alloy or titanium aluminum nitride ($Ti_xAl_yN_z$ where x, y and z indicate the proportion of each element in the alloy) is also contemplated to be utilized in place of titanium nitride. It is also contemplated that titanium nitride and titanium-aluminum alloy may be utilized together in a multi-layer structure such as a three layer stack of titanium nitride, aluminum, titanium nitride.

Pulling to the top can create stiction at the top side, which may be overcome by utilizing CST as discussed above. Alternatively, the stiction could be addressed by shaping the top electrode, and reducing the electrical field and pressure in strategic locations, for example adding bumps where electrostatic force is not applied.

By forming a cantilever with a waffle-type microstructure, a MEMS device may be designed for independent tuning of the cantilever rigidity. A cantilever so designed may be more reliable. Additionally, applying a voltage to a pull-up electrode may aid in overcoming stiction when the cantilever is pulled close to a lower RF line.

While the foregoing is directed to embodiments of the present invention, other and further embodiments of the invention may be devised without departing from the basic scope thereof, and the scope thereof is determined by the claims that follow.

**Claims**

1. A method of producing a micro-electromechanical device within a cavity that has one or more electrodes (104), one or more pull-in electrodes (106) and an RF electrode (108) disposed in the substrate, wherein the RF electrode (108) is disposed between a first electrode of the one or more electrodes (104) and a second electrode of the one or more electrodes (104), the method comprising:

   depositing a first sacrificial layer (112) over a dielectric layer (102);
   depositing a first structural layer (116) over the first sacrificial layer (112), wherein the first structural layer is coupled to the first electrode of the one or more electrodes (104) and the second electrode of the one or more electrodes (104);
   depositing a second sacrificial layer (118) over the first structural layer (116);
   forming one or more first vias (120) through the second sacrificial layer (118) to expose at least a portion of the first structural layer (116);
   depositing a second structural layer (124) within the one or more first vias (120) and over the second sacrificial layer (118);
   depositing a third sacrificial layer (126) over the second structural layer (124); and
   removing the first sacrificial layer (112), the second sacrificial layer (118) and the third sacrificial layer (126) to free the first structural layer (116) and the second structural layer (124) within the cavity.

2. The method of claim 1, wherein the third sacrificial layer (126) is removed prior to removing the second sacrificial layer (118).

3. The method of claim 1 or claim 2, further comprising:

   forming a second electrode (130) over the third sacrificial layer (126); and
   depositing an encapsulating layer (132) over the second electrode (130).

4. The method of any one of the preceding claims, wherein the first sacrificial layer (112) is removed after the third sacrificial layer (126) is removed.

5. The method of any one of the preceding claims, further comprising:

forming one or more second vias through the dielectric layer (102) to expose the first electrode and the second electrode of the one or more first electrodes (104);
depositing an electrically conductive material (110) into the one or more second vias over the first electrode and the second electrode of the one or more first electrodes (104);
forming one or more third vias (114) through the first sacrificial layer (112) to expose the electrically conductive material (110);
depositing the first structural layer (116) over the first sacrificial layer (112) and in the one or more third vias (114);
depositing an encapsulating layer (132) over the third sacrificial layer (126); and
introducing an etching gas through an opening in the encapsulating layer (132).

6. The method of claim 5, wherein forming one or more vias to expose the first electrode and the second electrode of the one or more first electrodes (104) comprises forming two vias to expose two first electrodes.

7. The method of claim 6, wherein the third sacrificial layer (126) is removed prior to removing the second sacrificial layer (118).

8. The method of claim 7, further comprising:

forming a second electrode (130) over the third sacrificial layer (126) prior to depositing the encapsulating layer (132).

9. A micro-electromechanical device within a cavity that has one or more electrodes (104), one or more pull-in electrodes (106) and an RF electrode (108) disposed in the substrate, wherein the RF electrode (108) is disposed between a first electrode of the one or more electrodes (104) and a second electrode of the one or more electrodes (104), comprising:

a first structural layer (116) coupled to the first and second electrodes of the one or more first electrodes (104) and extending over an RF electrode (108);
a second structural layer (124) spaced from the first structural layer (116) to define a space between the first structural layer (116) and the second structural layer (124); and
a plurality of posts (122) disposed within the space and coupled between the first structural layer (116) and the second structural layer (124), the first structural layer (116), the second structural layer (124) and the plurality of posts (122) forming a waffle pattern.

10. A micro-electromechanical device of claim 9, further comprising one or more electrically conductive compound springs spaced from the cantilever waffle pattern and disposed within the cavity.

11. The micro-electromechanical device of claim 9 or 10, wherein the first structural layer (116) is spaced from the pull-in electrodes (106) and the RF electrode (108).

12. The micro-electromechanical device of claim 11, further comprising:

a dielectric layer (102); and
the pull-in electrodes (106) embedded within the dielectric layer (102), wherein the pull-in electrodes (106) are embedded within the dielectric layer (102) and wherein the first structural layer (116), the second structural layer (124) and the plurality of posts (122) are collectively movable between a position in which the first structural layer (116) is in contact with the dielectric layer (102) and a position in which the first structural layer (116) is spaced from the dielectric layer (102).

13. The micro-electromechanical device of claim 12, wherein the first structural layer (116), the second structural layer (124) and the plurality of posts (122) are disposed within a cavity having a roof spaced from the second structural layer (124), the device further comprising:

one or more third electrodes (130) coupled to the roof and to a second dielectric layer (128) and spaced from the second structural layer (124) and wherein the first structural layer (116), the second structural layer (124) and the plurality of posts (124) are collectively movable between a position in which the second structural layer (124) is in contact with the second dielectric layer (128) and a position in which the second structural layer (124) is spaced from the second dielectric layer (128).

14. The micro-electromechanical device of any one of claims 9 to 13, wherein the first structural layer (116), the second structural layer (124) and the plurality of posts (122) are disposed within a cavity having a roof spaced from the second structural layer (124).

15. The micro-electromechanical device of claim 13, wherein the first structural layer (116), the second structural layer (124) and the plurality of posts (122) are movable within the cavity.

**16.** The device of claim 10, wherein the first structural layer (116) is movable from a position spaced from the one or more electrically conductive compound springs and a position in contact with the one or more electrically conductive springs.

**17.** The device of claim 16, wherein the one or more electrically conductive springs are movable from a position spaced from a dielectric layer and a position in contact with the dielectric layer.


**Patentansprüche**

**1.** Verfahren zur Herstellung einer mikroelektromechanischen Vorrichtung innerhalb eines Hohlraums, der eine oder mehrere Elektroden (104), eine oder mehrere Einziehelektroden (106) und eine HF-Elektrode (108) aufweist, die im Substrat angeordnet sind, wobei die HF-Elektrode (108) zwischen einer ersten Elektrode der einen oder mehreren Elektroden (104) und einer zweiten Elektrode der einen oder mehreren Elektroden (104) angeordnet ist, wobei das Verfahren umfasst:

Aufbringen einer ersten Opferschicht (112) über eine dielektrische Schicht (102); Aufbringen einer ersten strukturellen Schicht (116) über der ersten Opferschicht (112), wobei die erste strukturelle Schicht an die erste Elektrode der einen oder mehreren Elektroden (104) und die zweite Elektrode der einen oder mehreren Elektroden (104) gekoppelt ist;
Aufbringen einer zweiten Opferschicht (118) über die erste strukturelle Schicht (116);
Bilden eines oder mehrerer erster Verbindungskontakte (120) durch die zweite Opferschicht (118), um wenigstens einen Abschnitt der ersten strukturellen Schicht (116) freizulegen;
Aufbringen einer zweiten strukturellen Schicht (124) innerhalb des einen oder der mehreren ersten Verbindungskontakte (120) und über die zweite Opferschicht (118);
Aufbringen einer dritten Opferschicht (126) über die zweite strukturelle Schicht (124); und
Entfernen der ersten Opferschicht (112), der zweiten Opferschicht (118) und der dritten Opferschicht (126), um die erste strukturelle Schicht (116) und die zweite strukturelle Schicht (124) innerhalb des Hohlraums freizugeben.

**2.** Verfahren nach Anspruch 1, wobei die dritte Opferschicht (126) vor dem Entfernen der zweiten Opferschicht (118) entfernt wird.

**3.** Verfahren nach Anspruch 1 oder Anspruch 2, ferner umfassend:

Bilden einer zweiten Elektrode (130) über der dritten Opferschicht (126); und
Aufbringen einer Einkapselungsschicht (132) über die zweite Elektrode (130).

**4.** Verfahren nach irgendeinem der vorhergehenden Ansprüche, wobei die erste Opferschicht (112) entfernt wird nach dem die dritte Opferschicht (126) entfernt ist.

**5.** Verfahren nach irgendeinem der vorhergehenden Ansprüche, ferner umfassend:

Bilden eines oder mehrerer Verbindungskontakte durch die dielektrische Schicht (102), um die erste Elektrode und die zweite Elektrode der einen oder mehreren Elektroden (104) freizulegen;
Aufbringen eines elektrisch leitfähigen Materials (110) in den einen oder die mehreren zweiten Verbindungskontakt(e) über die erste Elektrode und die zweite Elektrode der einen oder mehreren ersten Elektroden (104);
Bilden eines oder mehrerer dritten Verbindungskontakte (114) durch die erste Opferschicht (112), um das elektrisch leitfähige Material (110) freizulegen;
Aufbringen der ersten strukturellen Schicht (116) über die erste Opferschicht (112) und in den einen oder die mehreren dritten Verbindungskontakte (114);
Aufbringen einer Einkapselungsschicht (132) über die dritte Opferschicht (126); und
Einführen eines Ätzgases durch eine Öffnung in der Einkapselungsschicht (132).

**6.** Verfahren nach Anspruch 5, wobei das Bilden eines oder mehrerer Verbindungskontakte zum Freilegen der ersten Elektrode und der zweiten Elektrode der einen oder mehreren ersten Elektroden (104) das Bilden von zwei Verbindungskontakten umfasst, um zwei erste Elektroden freizulegen.

**7.** Verfahren nach Anspruch 6, wobei die dritte Opferschicht (126) vor dem Entfernen der zweiten Opferschicht (118) entfernt wird.

**8.** Verfahren nach Anspruch 7, ferner umfassend:

Bilden einer zweiten Elektrode (130) über der dritten Opferschicht (126) vor dem Aufbringen der Einkapselungsschicht (132).

**9.** Mikroelektromechanische Vorrichtung innerhalb eines Hohlraums, der eine oder mehrere Elektroden (104), eine oder mehrere Einziehelektroden (106) und eine HF-Elektrode (108) aufweist, die im Substrat angeordnet sind, wobei die HF-Elektrode (108) zwischen einer ersten Elektrode der einen oder mehreren Elektroden (104) und einer zweiten Elektrode der einen oder mehreren Elektroden (104) angeordnet ist, umfassend:

Eine erste strukturelle Schicht (116), die an erste und zweite Elektroden der einen oder mehreren ersten Elektroden (104) gekoppelt ist und sich über eine HF-Elektrode (108) erstreckt;
Eine zweite strukturelle Schicht (124), die von der ersten strukturellen Schicht (116) beabstandet ist, um einen Raum zwischen der ersten strukturellen Schicht (116) und der zweiten strukturellen Schicht (124) zu definieren; und eine Vielzahl von Pfosten (122), die innerhalb des Raumes angeordnet und zwischen der ersten strukturellen Schicht (116) und der zweiten strukturellen Schicht (124) der ersten strukturellen Schicht (116) gekoppelt sind, wobei die zweite strukturelle Schicht (124) und die Vielzahl von Pfosten (122) ein Waffelmuster bilden.

10. Mikroelektromechanische Vorrichtung nach Anspruch 9, die ferner eine oder mehrere elektrisch leitfähige Verbundfedern umfasst, die vom Ausleger-Waffelmuster beabstandet und innerhalb des Hohlraums angeordnet sind.

11. Mikroelektromechanische Vorrichtung nach Anspruch 9 oder 10, wobei die erste strukturelle Schicht (116) von den Einziehelektroden (106) und der HF-Elektrode (108) beabstandet ist.

12. Mikroelektromechanische Vorrichtung nach Anspruch 11, ferner umfassend:

Eine dielektrische Schicht (102); und
die Einziehelektroden (106), die in die dielektrische Schicht (102) eingebettet sind, wobei die Einziehelektroden (106) in die dielektrische Schicht (102) eingebettet sind, und wobei die erste strukturelle Schicht (116), die zweite strukturelle Schicht (124) und die Vielzahl von Pfosten (122) kollektiv zwischen einer Position, in der die erste strukturelle Schicht (116) in Kontakt mit der dielektrischen Schicht (102) ist und einer Position, in der die erste strukturelle Schicht (116) von der dielektrischen Schicht (102) beabstandet ist, bewegbar ist.

13. Mikroelektromechanische Vorrichtung nach Anspruch 12, wobei die erste strukturelle Schicht (116), die zweite strukturelle Schicht (124) und die Vielzahl von Pfosten (122) innerhalb eines Hohlraums mit einem Dach angeordnet sind, das von der zweiten strukturellen Schicht (124), beabstandet ist, wobei die Vorrichtung ferner umfasst:

Eine oder mehrere dritte Elektroden (130), die an das Dach und an eine zweite dielektrische Schicht (128) und von der zweiten strukturellen Schicht (124) beabstandet sind, und wobei die erste strukturelle Schicht (116), die zweite strukturelle Schicht (124) und die Vielzahl von Pfosten (124) kollektiv zwischen einer Position, in der die zweite strukturelle Schicht (124) in Kontakt mit der zweiten dielektrischen Schicht (128) ist und einer Position, in der die zweite strukturelle Schicht (124) von der zweiten dielektrischen Schicht (128) beabstandet ist, bewegbar ist.

14. Mikroelektromechanische Vorrichtung nach irgendeinem der Ansprüche 9 bis 13, wobei die erste strukturelle Schicht (116), die zweite strukturelle Schicht (124) und die Vielzahl von Pfosten (122) innerhalb eines Hohlraums mit einem Dach angeordnet sind, das von der zweiten strukturellen Schicht (124) beabstandet ist.

15. Mikroelektromechanische Vorrichtung nach Anspruch 13, wobei die erste strukturelle Schicht (116), die zweite strukturelle Schicht (124) und die Vielzahl von Posten (122) innerhalb des Hohlraums bewegbar sind.

16. Vorrichtung nach Anspruch 10, wobei die erste strukturelle Schicht (116) aus einer Position bewegbar ist, die von der einen oder mehreren elektrisch leitfähigen Verbundfedern beabstandet ist und einer Position in Kontakt mit der einen oder mehreren elektrisch leitfähigen Federn bewegbar ist.

17. Vorrichtung nach Anspruch 16, wobei die eine oder mehrere elektrisch leitfähige Feder(n) aus einer Position, die von einer dielektrischen Schicht beabstandet ist und einer Position in Kontakt mit der dielektrischen Schicht bewegbar sind.

## Revendications

1. Procédé de fabrication d'un dispositif micro-électromécanique à l'intérieur d'une cavité qui comporte une ou plusieurs électrodes (104), une ou plusieurs électrodes d'excitation (106) et une électrode RF (108) disposées dans le substrat, **caractérisé en ce que** l'électrode RF (108) est placée entre une première électrode du groupe qui comporte une ou plusieurs électrodes (104) et une deuxième électrode du groupe qui comporte une ou plusieurs électrodes (104), le procédé consistant:

à déposer une première couche sacrificielle (112) sur une couche diélectrique (102);
à déposer une première couche strucurale (116) sur la première couche sacrificielle (112), **caractérisé en ce que** la première couche structurale est connectée à la première électrode de la ou des électrodes (104) et à la deuxième électrode de la ou des électrodes (104);

à déposer une deuxième couche sacrificielle (118) sur la première couche structurale (116);

à former un ou plusieurs trous via (120) à travers la deuxième couche sacrificielle (118) afin de mettre à découvert au moins une partie de la première couche structurale (116);

à déposer une deuxième couche structurale (124) à l'intérieur du ou des premiers trous via (120) et sur la deuxième couche sacrificielle (118);

à déposer une troisième couche sacrificielle (126) sur la deuxième couche structurale (124); et

à enlever la première couche sacrificielle (112), la deuxième couche sacrificielle (118) et la troisième couche sacrificielle (126) afin de libérer la première couche structurale (116) et la deuxième couche structurale (124) à l'intérieur de la cavité.

2. Procédé selon la revendication 1, **caractérisé en ce que** la troisième couche sacrificielle (126) est enlevée avant l'enlèvement de la deuxième couche sacrificielle (118).

3. Procédé selon la revendication 1 ou la revendication 2, qui consiste par ailleurs:

à former une deuxième électrode (130) au-dessus de la troisième couche sacrificielle (126); et
à déposer une couche d'enrobage (132) au-dessus de la deuxième électrode (130).

4. Procédé selon l'une quelconque des revendications précédentes, **caractérisé en ce que** la première couche sacrificielle (112) est enlevée après l'enlèvement de la troisième couche sacrificielle (126).

5. Procédé selon l'une quelconque des revendications précédentes, consistant par ailleurs:

à former un ou plusieurs deuxièmes trous via à travers la couche diélectrique (102) de afin de mettre à découvert la première électrode et la deuxième électrode du groupe qui comporte une ou plusieurs premières électrodes (104);
à déposer un matériau électriquement conducteur (110) dans le ou les deuxièmes trous via au-dessus de la première électrode et de la deuxième électrode du groupe qui comporte une ou plusieurs premières électrodes (104);
à former un ou plusieurs troisièmes trous via (114) à travers la première couche sacrificielle (112) afin de mettre à découvert le matériau électriquement conducteur (110);
à déposer la première couche structurale (116) au-dessus de la première couche sacrificielle (112) et dans le ou les troisièmes trous via (114);
à déposer une couche d'enrobage (132) au-dessus de la troisième couche sacrificielle (126); et
à introduire un gaz de gravure à travers une ouverture dans la couche d'enrobage (132).

6. Procédé selon la revendication 5, **caractérisé en ce que** la création d'un ou de plusieurs trous via pour mettre à découvert la première électrode et la deuxième électrode du groupe qui comporte une ou plusieurs électrodes (104) consiste entre autres à créer deux trous via afin de mettre à découvert deux premières électrodes.

7. Procédé selon la revendication 6, **caractérisé en ce que** la troisième couche sacrificielle (126) est enlevée avant l'enlèvement de la deuxième couche sacrificielle (118).

8. Procédé selon la revendication 7, qui consiste par ailleurs:

à former une deuxième électrode (130) au-dessus de la troisième couche sacrificielle (126) avant de déposer la couche d'enrobage (132).

9. Dispositif micro-électromécanique à l'intérieur d'une cavité comportant une ou plusieurs électrodes (104), une ou plusieurs électrodes d'excitation (106) et une électrode RF (108) disposées dans le substrat, **caractérisé en ce que** l'électrode RF (108) est placée entre une première électrode du groupe qui comporte une ou plusieurs électrodes (104) et une deuxième électrode du groupe qui comporte une ou plusieurs électrodes (104), le dispositif comprenant:

une première couche structurale (116) connectée à la première et à la deuxième électrodes du groupe qui comporte une ou plusieurs électrodes (104) et s'étendant au-dessus d'une électrode RF (108);
une deuxième couche structurale (124) écartée de la première couche structurale (116) de manière à définir un espace entre la première couche structurale (116) et la deuxième couche structurale (124); et
une pluralité de supports (122) disposés à l'intérieur de l'espace et connectés entre la première couche structurale (116) et la deuxième couche structurale (124), la première couche structurale (116), la deuxième couche structurale (124) et la pluralité de supports (122) formant une structure gaufrée.

**10.** Dispositif micro-électromécanique selon la revendication 9, comportant par ailleurs un ou plusieurs ressorts composés électriquement conducteurs écartés de la structure gaufrée en cantilever, et disposés à l'intérieur de la cavité.

**11.** Dispositif micro-électromécanique selon la revendication 9 ou 10, **caractérisé en ce que** la première couche structurale (116) est écartée des électrodes d'excitation (106) et de l'électrode RF (108).

**12.** Dispositif micro-électromécanique selon la revendication 11, comportant par ailleurs:

une couche diélectrique (102); et
les électrodes d'excitation (106) enrobées à l'intérieur de la couche diélectrique (102), **caractérisé en ce que** les électrodes d'excitation (106) sont enrobées à l'intérieur de la couche diélectrique (102) et **en ce que** la première couche structurale (116), la deuxième couche structurale (124), et la pluralité de supports (122) peuvent être déplacés collectivement entre une première position où la première couche structurale (116) se trouve en contact avec la couche diélectrique (102) et une autre position où la première couche structurale (116) est écartée de la couche diélectrique (102).

**13.** Dispositif micro-électromécanique selon la revendication 12, **caractérisé en ce que** la première couche structurale (116), la deuxième couche structurale (124), et la pluralité de supports (122) sont disposés à l'intérieur d'une cavité dont le toit est écarté de la deuxième couche structurale (124), le dispositif comprenant par ailleurs:

une ou plusieurs troisièmes électrodes (130) connectées au toit et à une deuxième couche diélectrique (128) et écartées de la deuxième couche structurale (124), et **caractérisé en ce que** la première couche structurale (116), la deuxième couche structurale (124), et la pluralité de supports (124) peuvent être déplacés collectivement entre une position où la deuxième couche structurale (124) se trouve en contact avec la deuxième couche diélectrique (128) et une autre position où la deuxième couche structurale (124) est écartée de la deuxième couche diélectrique (128).

**14.** Dispositif micro-électromécanique selon l'une quelconque des revendications 9 à 13, **caractérisé en ce que** la première couche structurale (116), la deuxième couche structurale (124), et la pluralité de supports (122) sont disposés à l'intérieur d'une cavité dont le toit est écarté de la deuxième couche structurale (124),

**15.** Dispositif micro-électromécanique selon la revendication 13, **caractérisé en ce que** la première couche structurale (116), la deuxième couche structurale (124), et la pluralité de supports (122) peuvent être déplacés à l'intérieur de la cavité.

**16.** Dispositif selon la revendication 10, **caractérisé en ce que** la première couche structurale (116) peut être déplacée entre une position qui est écartée du ou des ressorts composés électriquement conducteurs et une autre position en contact avec le ou les ressorts électriquement conducteurs.

**17.** Dispositif selon la revendication 16, **caractérisé en ce que** le ou les ressorts électriquement conducteurs peuvent être déplacée entre une position qui est écartée d'une couche diélectrique et une autre position en contact avec la couche diélectrique.

Figure 1A

Figure 1B

Figure 1C

Figure 1D

Figure 1E

118

Figure 1F

120

Figure 1G

122    124

Figure 1H

126

Figure 1I

Figure 1J

Figure 1K

Figure 1L

Figure 2A

MetB2

ViaBB

MetB1

Figure 2B

Roof

MetB2

MetB1

MetC

MetA

# Figure 3A

MetB1

MetC

# Figure 3B

MetC

Figure 3C

Figure 3D

Figure 3E

Figure 3F

Figure 4A

Figure 4B

403

407

Figure 4C

Figure 5A

Figure 5B

Figure 5C

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20030042117 A1
- US 20100116632 A1